# EUROPÄISCHE PATENTANMELDUNG

(11) **EP 0 997 943 A2**
(43) Veröffentlichungstag der Anmeldung: **03.05.2000**
(21) Anmeldenummer: 99120625.1
(22) Anmeldetag: 18.10.1999
(51) Int. Cl.: H01L 25/07, H01L 25/11, H01L 25/16

(54) **Halbleiter-Schaltungsanordnung, insbesondere Hochstromumrichter**

(30) Priorität: 30.10.1998 DE 19850153
(71) Anmelder: SIEMENS AKTIENGESELLSCHAFT, 80333 München (DE)
(72) Erfinder: Allwang, Reinhard, Dipl.-Ing., 92421 Schwandorf (DE); Götze, Thomas, Dipl.-Ing., 09113 Chemnitz (DE)

(57) **Zusammenfassung**

Für einen fertigungs- und montagetechnisch einfachen sowie niederinduktiven und vibrationsfesten Aufbau eines Umrichters ist oberhalb einer ersten Anordnungsebene (E1) mit einem eine Leistungseinheit aufnehmenden Substrat (S) eine zweite Anordnungsebene (E2) mit einer Zwischenkreis-Leiterplatte (ZP) und darauf fußseitig kontaktierten Zwischenkreis-Bauelementen (C;L) angeordnet; deren freie, obere Bauenden sind in einer dritten Anordnungsebene (E3) von einer wärmeleitenden Halterungsplatte (AL1) positionssichernd übergriffen, die nach einer Ausgestaltung der Erfindung auch als Unterlage für eine Ansteuer-Leiterplatte (SP) mitbenutzt ist.

## Beschreibung

Die Erfindung bezieht sich auf eine Halbleiter-Schaltungsanordnung, insbesondere Hochstromumrichter mit niedriger Zwischenkreisspannung, gemäß Patentanspruch 1; derartige Schaltungsanordnungen sind insbesondere zum Einsatz in Kraftfahrzeugen zwischen zumindest einem batteriegestützten Niederspannungs-Bordnetz einerseits und einem Starter-Generator als Anlasser bzw. Lader für die jeweilige Batterie andererseits vorgesehen. Sie dienen im Schubbetrieb des Kraftfahrzeuges zur Anpassung von Spannung und Leistung des dann als Generator arbeitenden Starter-Generators an die entsprechenden Betriebsdaten der jeweiligen nachzuladenden Batterie und beim Starten des dann als Motor arbeitenden Starter-Generators mit Hilfe der jeweiligen Batterie zur Gewährleistung eines hinreichenden Start-Drehmomentes mit entsprechend hohem Anfahrstrom.

Als wesentliche Bauteile einer solchen Schaltungsanordnung gelten insbesondere eine Anzahl von Halbleiter-Halbbrücken als Leistungsbauteile, eine Anzahl von Zwischenkreis-Bauelementen, insbesondere Kondensatoren, und eine Anzahl von Steuerelementen, insbesondere Treiberstufen.

Aus der DE 196 45 636 C1 ist eine Halbleiter-Schaltungsanordnung zur Ansteuerung eines Elektromotors bekannt, bei der eine Leistungseinheit mit elektronischen Halbleitern auf der Oberseite eines DCB-Substrats angeordnet und kontaktiert ist, das mit seiner Unterseite unmittelbar auf der Oberfläche einer Kühlereinheit aufliegt; parallel und beabstandet liegt oberhalb des DCB-Substrats eine Trägerplatte, auf deren Oberseite und Unterseite Halbleiter-Bauelemente einer zugehörigen Ansteuereinheit gehaltert und kontaktiert, insbesondere verlötet, sind. Senkrechte, mit dem DCB-Substrat verlötete Kontaktstifte dienen der Kontaktierung zwischen der Leistungseinheit auf dem DCB-Substrat einerseits und der Ansteuereinheit auf der Trägerplatte andererseits. Parallel zu dem DCB-Substrat und der Trägerplatte führen Gleichspannungs-Stromschienen durch einen Gehäusekörper nach außen zu dort auf der Oberseite der Kühlereinheit gelagerte Zwischenkreis-Kondensatoren; Anschlußschienen zur Wechsel- bzw. Drehstromseite der Schaltungsanordnung sind senkrecht zum DCB-Substrat und zur Trägerplatte aus dem Gehäusekörper nach außen geführt.

Gemäß Aufgabe vorliegender Erfindung soll die Voraussetzung für ein als Großserienprodukt mit geringem Aufwand fertig- und montierbaren niederinduktiven Umrichter, insbesondere Hochstrom-Umrichter mit niedriger Zwischenkreisspannung, geschaffen werden, der bei kompakter Bauart auch rauhen Betriebseinsätzen, wie z.B. in einem Kraftfahrzeug, gewachsen ist.

Die Lösung der vorgenannten Aufgabe gelingt erfindungsgemäß durch eine Halbleiter-Schaltungsanordnung gemäß Patentanspruch 1; vorteilhafte Ausgestaltungen der Halbleiter-Schaltungsanordnung sind Gegenstand der Unteransprüche 2-10.

Die erfindungsgemäße Halbleiter-Schaltungsanordnung erlaubt in einfacher Fertigungs- und Montagetechnik eine extrem niederinduktive Anschlußverbindung zwischen dem Substrat in der ersten Anordnungsebene und der darüberliegenden, an ihrer Oberseite mit Bauelementen bestückten, vorzugsweise als Funktionseinheit vormontierbaren, Zwischenkreis-Leiterplatte in der gering beabstandeten zweiten Anordnungsebene bei für den Einsatz in Kraftfahrzeugen Vorteilhaftem besonders vibrationsfestem Aufbau positionssicherer Umfassung der freien Bauenden der von der zweiten Anordnungsebene hochstehenden Zwischenkreis-Bauelemente durch die Halterungsplatte in der dritten Ebene.

Zweckmäßigerweise weist die Halterungsplatte, insbesondere als Aluminiumplatte, eine gute Wärmeableitung zu einem äußeren Anordnungsrahmen auf, der seinerseits in wärmeleitender Verbindung mit einer Kühleinheit steht. Zum Zwecke einer guten Wärmefestigkeit liegt auch das Substrat mit seiner Unterseite mittelbar, insbesondere über eine Zwischen-Wärmeleitplatte, auf der Oberfläche dieser Kühleinheit auf, die auch in gut wärmeleitender Verbindung mit dem äußeren Anordnungsrahmen steht und nach einer Ausgestaltung der Erfindung auch als mechanische Halterung für die Zwischenkreis-Leiterplatte mitbenutzt ist.

In weiterer fertigungs- und montagetechnischer Vereinfachung sowie im Sinne einer kompakten Baueinheit ist vorgesehen, auf der Oberseite der Halterungsplatte eine Ansteuer-Leiterplatte anzuordnen, die zur Ansteuerung der Leistungseinheit mit dieser, z.B. über eine flexible Leitung, in Funktionsverbindung steht.

Die einfach zu montierende und zu fixierende Halterungsplatte vereint also die vibrationsfeste Fixierung der Zwischenkreis-Bauelemente und der Ansteuer-Leiterplatte sowie die Wärmeentlastung dieser Bauelemente über den Anordnungsrahmen an die Kühleinheit.

Insbesondere in Anwendung auf ein Kraftfahrzeug, bei dem üblicherweise der eine batterieseitige Gleichspannungspol als Massepol ausgebildet ist, ist zur weiteren Erhöhung der Kompaktheit der Halbleiter-Schaltungsanordnung bei gleichzeitig extrem niederinduktiver Aufbauweise eine Ausbildung des Substrates mit einem Leiterbahnen-Layout sowohl an der Oberseite als auch mit einem, vorzugsweise grobstrukturierten, Leiterbahnen-Layout an der Unterseite seines Isolations-Zwischenträgers und eine Durch- bzw. Seitenrandkontaktierung zwischen den Leiterbahnen der Oberseite einerseits und den als Masse rückleitenden, zur Kühleinheit unisolierten Leiterbahnen der Unterseite vorgesehen.

Zur Fertigungs- und Montagevereinfachung bei gleichzeitig kompaktem Aufbau ist eine gegenseitige elektrische FunktionsKontaktverbindung beim Zusammenbau der ersten Anordnungsebene mit der zweiten Anordnungsebene mittels aus der einen Anordnungsebene vorstehenden, in korrespondierende Kontaktaufnahmen der anderen Anordnungsebene einpreßbarer Kontaktstifte vorgesehen.

Die Erfindung sowie weitere vorteilhafte Ausgestaltungen der Erfindung werden im folgenden anhand schematisch dargestellter Ausführungsbeispiele in der Zeichnung näher erläutert; darin zeigen:
- FIG 1: in einem Schnittbild einen Hochstrom-Umrichter, insbesondere für ein Kraftfahrzeug;
- FIG 2: eine Ausschnittvergrößerung II aus FIG 1;
- FIG 3: den Hochstrom-Umrichter gemäß FIG 1 im Schnittverlauf III-III;
- FIG 4: den Hochstrom-Umrichter gemäß FIG 1 im Schnittverlauf IV-IV.

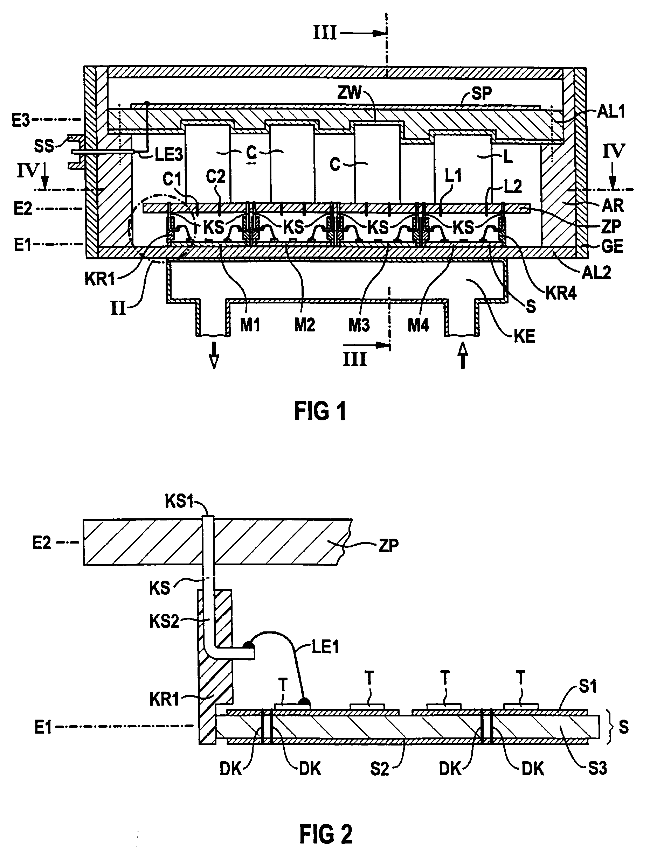

In einer ersten Anordnungsebene E1 ist eine Leistungseinheit mit vier Modulen M1-M4, bestehend aus jeweils mit Halbleitern T bestückten, von einem Kunststoffrahmen KR1 bzw. KR2 bzw. KR3 bzw. KR4 umfaßten DCB-Substraten S angeordnet. Jedes der Module M1-M3 ist jeweils als Teil einer Umrichter-Brückenschaltung je einem Brückenzweig mit Anschluß an eine Phase U bzw. V bzw. W eines Starter-Generators SG zugeordnet; das Modul M4 enthält den Leistungsteil eines Spannungswandlers. Die Kunststoffrahmen KR1-KR4 sind mit Kontaktstiften KS, insbesondere durch Einstecken bzw. Eingießen, bestückt und in üblicher Bond-Technik mit den auf den DCB-Substraten verlöteten Halbleitern T über Leitungen LE1 - wie insbesondere aus der Detailvergrößerung gemäß FIG 2 ersichtlich - verbunden. Die mit ihrem unteren Ende KS2 in dem jeweiligen Kunststoffrahmen KR1-KR4 gehaltenen Kontaktstifte KS ragen mit einem freien Ende KS1 aus dem Kunststoffrahmen, insbesondere senkrecht nach oben, heraus.

Die freien Enden KS1 der Kontaktstifte KS sind zur Kontaktierung mit korrespondierenden Kontaktaufnahmen KA in einer Zwischenkreis-Leiterplatte ZP, insbesondere einer Multilayer-Leiterplatte, vorgesehen, die betriebsmäßig in geringem Abstand zu der ersten Anordnungsebene E1 oberhalb der Substrate S in einer zweiten Anordnungsebene E2 angeordnet ist. Diese Zwischenkreis-Leiterplatte ZP ist zweckmäßigerweise vor ihrem Zusammenbau mit der ersten Anordnungsebene E1 als Vormontageeinheit mit Zwischenkreis-Bauelementen, insbesondere mit Kondensatoren C und Induktivitäten L, dadurch bestückt, daß diese Zwischenkreis-Bauelemente C;L mit ihren fußseitigen Kontaktenden C1;C2 bzw. L1;L2 bis zu einem Layout-Anschluß auf der Unterseite der Zwischenkreis-Leiterplatte ZP durchgesteckt und dort durch einfaches Schwallöten mit den entsprechenden Leiterbahnen kontaktiert sind. Beim Zusammenbau der derart zuvor mit den Zwischenkreis-Bauelementen C;L bestückten und kontaktierten Zwischenkreis-Leiterplatte ZP einerseits mit der ersten Anordnungsebene E1 andererseits werden die freien Kontaktenden KS1 der in den Kunststoffrahmen KR1-KR4 der Module M1-M4 positionierten Kontaktstifte KS in die korrespondierenden Kontaktaufnahmen KA der Zwischenkreis-Leiterplatte ZP selbsttätig einpreßkontaktiert.

Oberhalb der freien Bauenden der Zwischenkreis-Bauelemente C;L ist in einer dritten Anordnungsebene E3 eine Halterungsplatte AL1 seitlich in einem Anordnungsrahmen AR, z.B. mittels Schraubbefestigung, fixiert. In vorteilhafter Weise übergreift bzw. umgreift diese Halterungsplatte AL1 formschlüssig die freien Bauenden der Zwischenkreis-Bauelemente C;L derart, daß diese auch gegenüber stärkeren Stoßbelastungen vibrationsfest gesichert sind. Nach einer Ausgestaltung der Erfindung ist die Halterungsplatte AL1 als Wärmeleitplatte, insbesondere als Aluminiumplatte, ausgebildet.

Nach einer weiteren Ausgestaltung der Erfindung ist zwischen der Halterungsplatte AL1 und den von dieser positionssichernd umfaßten freien Bauenden der Zwischenkreis-Bauelemente C;L eine wärmeleitende elastische Zwischenlage ZW, insbesondere ein Wärmeleitgummi, angeordnet, derart daß von den Zwischenkreis-Bauelementen C;L Wärme über die formanpassbare Zwischenlage ZW und die Halterungsplatte AL1 an den äußeren Anordnungsrahmen AR weitergegeben werden kann, der seinerseits in vorteilhafter Weise in gut wärmeleitender Verbindung mit einer Zwischen-Wärmeleitplatte AL2, insbesondere Aluminiumplatte, steht, über welche auch die Module M1-M4 bzw. deren Substrat S vorteilhaft wärmeabgebend auf der Oberfläche einer Kühleinheit KE aufliegen.

Die Zwischen-Wärmeleitplatte AL2 dient auch der mechanischen Fixierung der ersten und zweiten Anordnungsebene E1 bzw.E2. Dazu dienen z.B. hier nicht dargestellte Schrauben, die auf der Zwischenkreis-Leiterplatte ZP aufliegen, durch Schraublöcher SR1-SR4 der Kunststoffrahmen KR1-KR4 der Module M1-M4 hindurchreichen und in die Zwischen-Wärmeleitplatte AL2 einschraubbar sind.

Zum Schutz gegen eine Wärmebelastung von außen ist die gesamte Schaltungsanordnung durch ein zu dem Anordnungsrahmen AR äußeres, thermisch isolierendes Gehäuse GE eingekapselt.

In weiterer fertigungs- und montagetechnischer Vereinfachung und im Sinne einer möglichst kompakten Baueinheit ist die Halterungsplatte AL1 gleichzeitig dazu benutzt, auf ihrer Oberseite eine Ansteuereinheit, insbesondere in Form einer Ansteuer-Leiterplatte SP, aufzunehmen; die Ansteuer-Leiterplatte SP ist über eine Leitungsverbindung LE2 mit der Zwischenkreis-Leiterplatte ZP und über die Kontaktstifte KS mit der Leistungseinheit der Module M1-M4 sowie über eine Leitungsverbindung LE3 mit einem äußeren Signal-Stecker SS kontaktierbar ist.

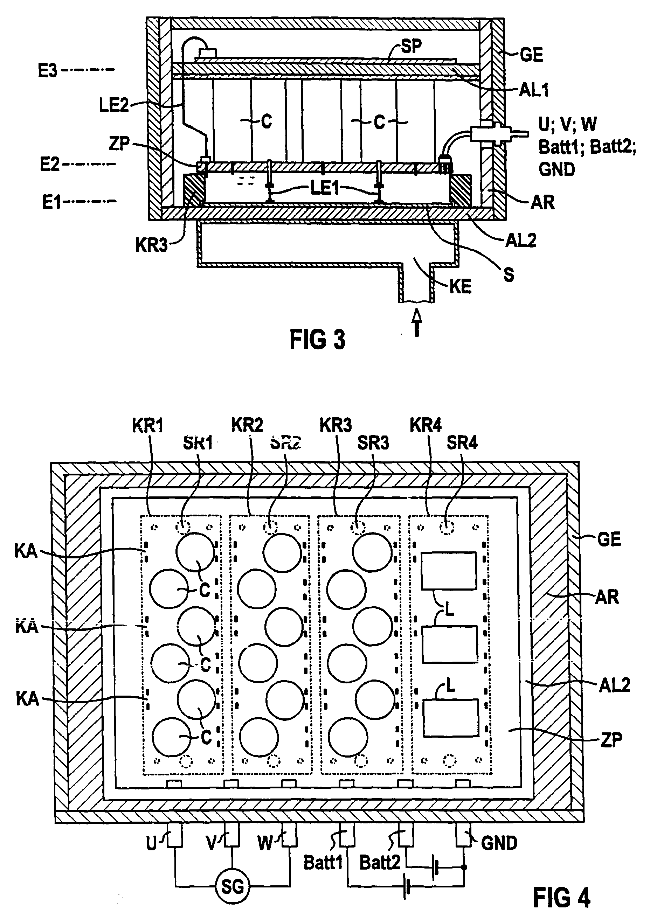

Für eine besonders einfache und nur kurze Leitungswege erfordernde Anschlußmöglichkeit der Wechsel- bzw. Drehstromseite des Starter-Generators bzw. der Gleichstromseite der Batterie sind entsprechende Wechsel- bzw. Drehstrom-Anschlüsse U;V;W des Stater-Generators SG einerseits und Gleichstrom-Anschlüsse Bat1;Bat2;GND für zwei Bordnetze andererseits - wie insbesondere aus FIG 3 ersichtlich - von einem seitlichen Gehäuseanschluß auf kurzem Weg zu der Zwischenkreis-Leiterplatte ZP geführt.
Ausgehend von der Erkenntnis, daß in einem Kraftfahrzeug üblicherweise einer der beiden Gleichstrom-Anschlüsse, vorzugsweise der negative Gleichstrom-Anschluß einen Massepotential-Anschluß GND bildet, ist im Sinne einer noch größeren Kompaktheit bei gleichzeitig durch besonders kurze Anschlußwege verminderbarer Induktivität - wie insbesondere aus der vergrößerten Detaildarstellung gemäß FIG 2 ersichtlich - eine Durchkontaktierung des Substrats S der Module M1-M2 zwischen der oberen Substratebene S1 und der unteren Substratebene S2 durch den Isolations-Zwischenträger S3, insbesondere einen Keramik-Zwischenträger, mittels elektrischer Verbindungen DK derart vorgesehen, daß die Massekontakt-Verbindungen der auf der Oberseite des Substrats S angeordneten Halbleiter-Bauelementen T über Kontaktbahnen DK zu der, vorzugsweise im Sinne grobstrukturierter Massepotential-Leiterbahnen ausgebildeten, Unterseite S2 des Substrates S geführt sind; im vorliegenden Fall wird davon ausgegangen, daß der negative Massepotential-Anschluß GND und die Kühleinheit KE das gleiche Spannungs-Potential aufweisen.

## Patentansprüche

1. Halbleiter-Schaltungsanordnung, insbesondere Hochstromumrichter mit niedriger Zwischenkreispannung, enthaltend:
- eine erste Anordnungsebene (E1) mit einer Leistungseinheit mit auf der Oberseite eines Substrats (S), insbesondere eines DCB-Substrats, angeordneten und mit diesem kontaktierten Halbleitern (T);
- eine zweite, oberhalb zu der ersten gering beabstandete, Anordnungsebene (E2) mit auf der Oberseite einer Zwischenkreis-Leiterplatte (ZP), insbesondere einer Multilayer-Leiterplatte, angeordneten und mit dieser kontaktierten Zwischenkreis-Bauelementen (C;L);
- eine dritte, oberhalb zu der zweiten beabstandete Anordnungsebene (E3) mit einer von einem äußeren Anordnungsrahmen (AR) aufgenommenen Halterungsplatte (AL1), insbesondere gut wärmeleitenden Aluminiumplatte;
- mit einer Positionssicherung der ihrem Kontaktierungsende abgewandten freien Bauenden der Zwischenkreis-Bauelemente (C;L) durch die Halterungsplatte (AL1).

2. Halbleiter-Schaltungsanordnung nach Anspruch 1, enthaltend:
- eine formschlüssige, insbesondere beim Zusammenbau der zweiten und dritten Anordnungsebene (E2 bzw. E3), auf die freien Bauenden aufsteckbare Umfassung der Zwischenkreis-Bauelemente (C;L) durch die Halterungsplatte (AL1).

3. Halbleiter-Schaltungsanordnung nach Anspruch 1 und/oder 2, enthaltend:
- eine gut wärmeleitende elastische Zwischenlage (ZW), insbesondere in Form eines Wärmeleitgummis, zwischen der Halterungsplatte (AL1) und den freien Bauenden der Zwischenkreis-Bauelemente (C;L).

4. Halbleiter-Schaltungsanordnung nach zumindest einem der Ansprüche 1-3, enthaltend:
- eine oberhalb der Halterungsplatte (AL1) von dieser aufgenommen, mit der Leistungseinheit der ersten Anordnungsebene (E1) in Funktionsverbindung stehende Ansteuereinheit, insbesondere auf einer Ansteuer-Leiterplatte (SP).

5. Halbleiter-Schaltungsanordnung nach zumindest einem der Ansprüche 1-4, enthaltend:
- eine gegenseitige elektrische Funktions-Kontaktverbindung beim Zusammenbau der ersten Anordnungsebene (E1) mit der zweiten Anordnungsebene (E2) mittels aus der einen Anordnungsebene (E1 bzw. E2) vorstehenden, in korrespondierende Kontaktaufnahmen (KA) der anderen Anordnungsebene (E2 bzw. E1) einpreßbarer Kontaktstifte (KS).

6. Halbleiter-Schaltungsanordnung nach zumindest einem der Ansprüche 1-5, enthaltend:
- eine Aufnahme des Substrats (S) innerhalb zumindest eines elektrisch isolierenden Rahmens (KR1-KR4), insbesondere Kunststoff-Rahmens, und eine Aufnahme der Kontaktstifte (KS) in den Rahmen (KR1-KR4 ) mit gegen die zweite Anordnungsebene (2) vorstehenden und in deren Kontaktaufnahmen (KA) beim gegenseitigen Zusammenbau der Anordnungsebenen (E1 bzw. E2) einpreßbaren freien Kontaktstift-Enden (KS1).

7. Halbleiter-Schaltungsanordnung nach zumindest einem der Ansprüche 1-6, enthaltend:
- eine Kontaktierung der Zwischenkreis-Bauelemente (C;L) mit der Zwischenkreis-Leiterplatte (ZP) der zweiten Anordnungsebene (E2) mittels Durchkontaktierung der elektrischen Anschlüsse (C1;C2 bzw.L1;L2) der Zwischenkreis-Bauelemente (C;L) bis zur Unterseite der Zwischenkreis-Leiterplatte (ZP) und Verbindung, insbesondere Schwallötung, mit entsprechenden Unterseite-Leiterbahnen.

8. Halbleiter-Schaltunganordnung nach zumindest einem der Ansprüche 1-7, enthaltend:
- zu der zweiten Anordnungsebene (E2), insbesondere deren Zwischenkreis-Leiterplatte (ZP), geführte äußere Wechsel- bzw. Drehstromanschlüsse (U;V;W) bzw. Gleichstromanschlüsse (Batt1;Batt2;GND).

9. Halbleiter-Schaltungsanordnung nach zumindest einer der Ansprüche 1-8, enthaltend:
- eine Ausbildung des Substrats (S) mit einem Leiterbahnen-Layout sowohl an der Oberseite (S1) als auch an der Unterseite (S2) seines Isolations-Zwischenträgers (S3), insbesondere Keramikträgers;
- eine Durch- bzw. Seitenrand-Kontaktierung zwischen Leiterbahnen der Oberseite (S1) einerseits und der Unterseite (S2) andererseits;
- eine Ausbildung der Unterseite (S2) des Substrates (S) als ein Gleichstrom-Anschluß, insbesondere als ein Massepotential-Anschluß GND, der Leistungseinheit.

10. Halbleiter-Schaltungsanordnung nach zumindest einem der Ansprüche 1-9, enthaltend:
- eine Verwendung als Umrichter zwischen zumindest einem batteriegestützten Gleichstrom-Bordnetz (Batt1;Batt2;GND) und einem Starter-Generator (SG) in einem Kraftfahrzeug.
